(19) Europäisches Patentamt
European Patent Office
Office européen des brevets

(11) EP 2 339 747 A1

(12) DEMANDE DE BREVET EUROPEEN

(43) Date de publication:
29.06.2011 Bulletin 2011/26

(51) Int Cl.:
H03F 3/45 (2006.01)          H03F 1/26 (2006.01)
H03F 1/32 (2006.01)

(21) Numéro de dépôt: 10193006.3

(22) Date de dépôt: 29.11.2010

(84) Etats contractants désignés:
AL AT BE BG CH CY CZ DE DK EE ES FI FR GB
GR HR HU IE IS IT LI LT LU LV MC MK MT NL NO
PL PT RO RS SE SI SK SM TR
Etats d'extension désignés:
BA ME

(30) Priorité: 28.12.2009 FR 0959625

(71) Demandeur: STmicroelectronics SA
92120 Montrouge (FR)

(72) Inventeur: Ohannaidh, Eoin
38190, LAVAL (FR)

(74) Mandataire: de Beaumont, Michel
1bis, rue Champollion
38000 Grenoble (FR)

(54) **Circuit de polarisation pour amplificateur différentiel**

(57) L'invention concerne un circuit de polarisation, pour commander le courant circulant dans une paire différentielle (102, 104) d'un circuit amplificateur différentiel (101), comprenant : une première branche comprenant une première résistance (306), un premier dispositif de transistor (308) et un deuxième dispositif de transistor (310) en série, et une seconde branche comprenant un troisième dispositif de transistor (314) et un quatrième dispositif de transistor (316) en série ; et un amplificateur opérationnel (318) ayant un noeud de sortie couplé au noeud de commande des deuxième et quatrième dispositifs de transistor, le noeud de sortie étant agencé pour commander le courant circulant dans la paire différentielle, le circuit étant caractérisé en ce que la seconde branche comprend une seconde résistance (312) et en ce qu'un noeud de commande du troisième dispositif de transistor est couplé à un premier noeud (324) disposé entre la première résistance et le premier dispositif de transistor, et un noeud de commande du premier dispositif de transistor est couplé à un second noeud (322) entre la deuxième résistance et le troisième dispositif de transistor.

Fig 3

EP 2 339 747 A1

**Description**

Domaine de l'invention

La présente invention concerne un circuit de polarisation pour un amplificateur différentiel et en particulier un circuit de polarisation pour commander le courant dans une paire différentielle d'un amplificateur différentiel.

Arrière-plan de l'invention

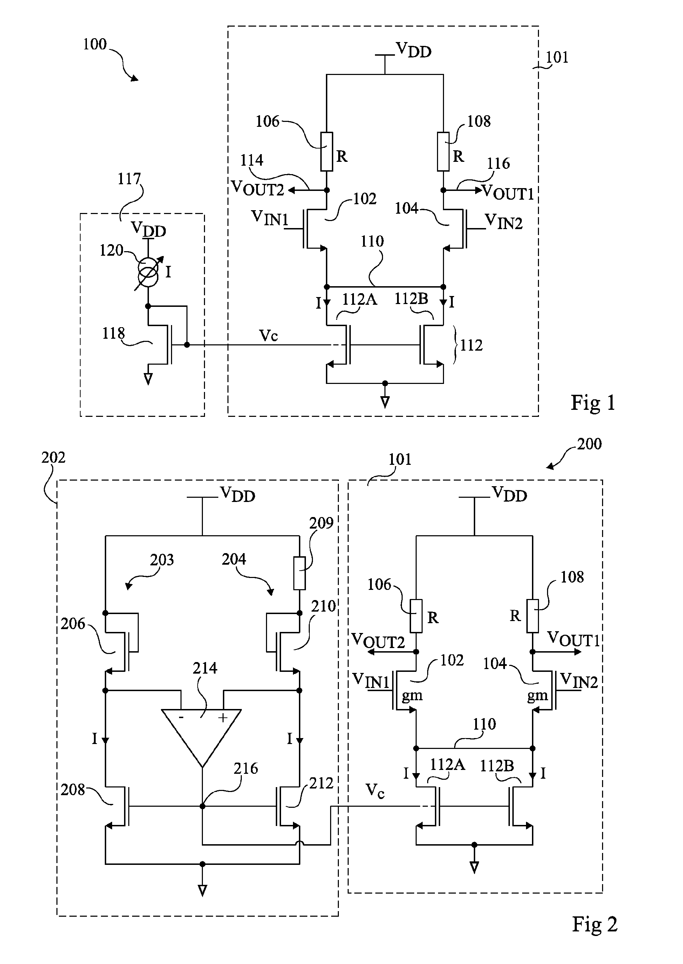

La figure 1 représente un circuit amplificateur 100 comprenant un circuit amplificateur différentiel 101. Le circuit 101 comprend une paire différentielle de transistors 102, 104 recevant sur leurs grilles des tensions d'entrée différentielles $V_{IN1}$ et $V_{IN2}$, respectivement. Le transistor 102 de la paire différentielle est par exemple un transistor MOS dont le drain est couplé à une tension d'alimentation haute $V_{DD}$ par une résistance 106 alors que le transistor 104 est par exemple un transistor MOS dont le drain est couplé à $V_{DD}$ par une résistance 108. Les transistors 102, 104 ont leurs sources couplées l'une à l'autre par une ligne 110. Une source de courant 112 est prévue entre les sources des transistors 102, 104 et la masse (Ground), et comprend des premier et second transistors 112A et 112B.

Le circuit amplificateur différentiel 101 fournit des signaux de sortie différentiels $V_{OUT2}$ et $V_{OUT1}$ sur des lignes de sortie 114 et 116 respectivement couplées aux drains des transistors 102 et 104. Le gain de l'amplificateur est déterminé par la transconductance "GM" des transistors 102 et 104 et la résistance R de chacun des transistors 106, 108. Plus particulièrement, le gain est égal à GMxR.

Pendant le fonctionnement de l'amplificateur différentiel 100, le gain peut s'écarter des valeurs attendues en raison de variations de température et/ou de conditions de fabrication qui provoquent des variations des valeurs de GM et de R. Ceci n'est pas souhaitable dans de nombreuses applications de l'amplificateur 100 car un excès de gain peut provoquer des défauts de linéarité, par exemple une excursion du signal de sortie trop grande pour les capacités du circuit, et un gain trop faible peut provoquer des problèmes de bruit, par exemple l'excursion du signal de sortie peut ne pas être notablement supérieure au bruit produit par le circuit.

Une solution pour éviter cet inconvénient serait de remplacer les résistances 106 et 108 par des transistors. Alors, des variations de la transconductance GM seraient compensées, et on aurait un gain plus constant. Toutefois, un problème avec une telle solution serait que ces transistors présenteraient une chute de tension drain-source plus élevée que la chute de tension aux bornes des résistances 106 et 108. Ainsi, pour conserver la même tension de sortie, on aurait besoin d'une tension d'alimentation plus élevée, ce qui est un problème par suite de la tendance générale dans l'industrie à réduire les tensions d'alimentation.

Comme cela est représenté en figure 1, une autre solution consiste à commander la source de courant 112 de sorte que le courant total 2I dans la source de courant 112 varie pour s'opposer à des variations de la résistance R et de la transconductance GM. Un circuit de polarisation 117 est utilisé pour commander la source de courant 112 et comprend un transistor 118 en série avec une source de courant variable 120. Le courant I circulant dans la source de courant variable 120 adapte le courant I circulant dans chacun des transistors 112A, 112B de la source de courant variable 112.

Toutefois, il est difficile de concevoir la source de courant variable 120 pour s'adapter avec précision aux variations de R et de GM survenant dans les composants 102, 104, 106 et 108 du circuit amplificateur différentiel 101. Il existe donc un besoin d'un amplificateur différentiel ayant un circuit de polarisation qui commande efficacement la source de courant 112.

Le brevet US 6 275 109 décrit un circuit de polarisation comprenant un amplificateur opérationnel.

Résumé

Un objet de modes de réalisation de la présente invention est de traiter au moins partiellement un ou plusieurs des besoins de l'art antérieur.

Selon un aspect de la présente invention, il est prévu un circuit de polarisation pour commander le courant circulant dans une paire différentielle d'un circuit amplificateur différentiel, le circuit de polarisation comprenant des première et seconde branches dont chacune est couplée entre des première et seconde tensions d'alimentation, la première branche comprenant une première résistance, un premier dispositif de transistor et un deuxième dispositif de transistor en série, et la seconde branche comprenant un troisième dispositif de transistor et un quatrième dispositif de transistor en série ; et un amplificateur opérationnel ayant une première entrée couplée à un noeud disposé entre les premier et deuxième dispositifs de transistor, une seconde entrée couplée à un noeud entre les troisième et quatrième dispositifs de transistor et un noeud de sortie couplé au noeud de commande des deuxième et quatrième dispositifs de transistor, le noeud de sortie étant agencé pour commander le courant circulant dans la paire différentielle, le circuit étant caractérisé en ce que la seconde branche comprend une seconde résistance, et en ce qu'un noeud de commande du troisième dispositif de transistor est couplé à un premier noeud disposé entre la première résistance et le premier dispositif de transistor, et un noeud de commande du premier dispositif de transistor est couplé à un second noeud entre la deuxième résistance et le troisième dispositif de transistor.

Selon un mode de réalisation de la présente invention, chacun des premier et deuxième dispositifs de transistor comprend deux transistors en parallèle.

Selon un mode de réalisation de la présente invention, les transistors des premier et troisième dispositifs de transistor ont la même largeur que chaque transistor de la paire différentielle.

Selon un mode de réalisation de la présente invention, le quatrième dispositif de transistor comprend une pluralité de transistors en parallèle, chacun ayant la même largeur qu'un transistor de la source de courant variable.

Selon un mode de réalisation de la présente invention, le rapport entre le nombre de transistors du quatrième dispositif de transistor et du deuxième dispositif de transistor est choisi pour être égal à $(N+1)/(N-1)$, où $N$ est le rapport entre un courant de repos et un courant de signal acceptable maximum.

Selon un mode de réalisation de la présente invention, le rapport entre le nombre de transistors du quatrième dispositif de transistor et du deuxième dispositif de transistor est dans une plage de 1 à 20, ou par exemple dans une plage de 1,2 à 20.

Selon un mode de réalisation de la présente invention, le circuit de polarisation comprend en outre au moins une résistance couplée entre les premier et deuxième noeuds.

Selon un mode de réalisation de la présente invention, le quatrième dispositif de transistor comprend trois transistors en parallèle, chacun ayant une largeur égale à la largeur des transistors du deuxième dispositif de transistor de la première branche.

Selon un aspect de la présente invention, il est prévu un circuit amplificateur différentiel comprenant le circuit de polarisation ci-dessus, et un circuit amplificateur comprenant une première résistance couplée entre la première tension d'alimentation et un premier transistor de la paire différentielle ; une deuxième résistance couplée entre la première tension d'alimentation et un deuxième transistor de la paire différentielle ; et une source de courant variable commandée par le signal de sortie pour commander le courant circulant dans la paire différentielle.

Selon un mode de réalisation de la présente invention, le circuit amplificateur comprend un premier noeud de sortie différentiel entre le premier transistor de la paire différentielle et la première résistance et un second noeud de sortie différentiel entre le second transistor de la paire différentielle et la deuxième résistance.

Selon un mode de réalisation de la présente invention, le circuit amplificateur comprend en outre une première résistance variable couplée entre les sources des premier et deuxième transistors de la paire différentielle et la source de courant variable comprend un premier transistor couplé entre la source du premier transistor de la paire différentielle et la seconde tension d'alimentation ; et un deuxième transistor couplé entre la source du deuxième transistor de la paire différentielle et la seconde tension d'alimentation.

Selon un aspect de la présente invention, il est prévu un amplificateur à gain variable comprenant l'amplificateur différentiel ci-dessus.

Selon un aspect de la présente invention, il est prévu un dispositif électronique comprenant l'amplificateur différentiel ci-dessus.

Selon un aspect de la présente invention, il est prévu une commande de disque dur pour lire un disque de mémorisation de données électroniques comprenant une tête de lecture et l'amplificateur différentiel ci-dessus.

Selon un aspect de la présente invention, il est prévu un amplificateur comprenant une pluralité d'amplificateurs différentiels tels que ci-dessus, en série.

Selon un aspect de la présente invention, les premier, deuxième, troisième et quatrième dispositifs de transistor du circuit de polarisation, et la paire différentielle du circuit amplificateur, comprennent des transistors de type MOS.

Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :

la figure 1, décrite ci-dessus, représente schématiquement un amplificateur différentiel ;
la figure 2 représente schématiquement un amplificateur différentiel comprenant un circuit de polarisation selon un exemple ;
les figures 3 à 5 représentent schématiquement des amplificateurs différentiels comprenant des circuits de polarisation selon des modes de réalisation de la présente invention ; et
la figure 6 représente schématiquement un dispositif électronique selon un mode de réalisation de la présente invention.

Dans les figures, de mêmes caractéristiques ont été désignées par de mêmes références.

Description détaillée de modes de réalisation de la présente invention

La figure 2 représente un amplificateur différentiel 200 comprenant un circuit amplificateur 101 identique à celui de la figure 1 qui ne sera pas décrit à nouveau en détail. La figure 2 représente également un exemple de circuit de polarisation 202 pour commander la source de courant variable 112 du circuit amplificateur 101.

Le circuit de polarisation 202 comprend des branches 203 et 204. La branche 203 comprend des transistors MOS 206 et 208 en série entre une tension d'alimentation $V_{DD}$ et la masse. La branche 204 comprend une résistance 209, un transistor MOS 210 et un transistor MOS 212 en série entre $V_{DD}$ et la masse. Les transistors 206 et 210 ont leur grille couplée à leur drain. Les sources des transistors 206 et 210 sont couplées respectivement aux drains des transistors 208 et 212 et également aux entrées respectives d'un amplificateur opérationnel 214. La sortie de l'amplificateur opérationnel 214 est couplée à un noeud 216 lui-même couplé aux grilles des transistors 208 et 212 et à la source de courant variable 112 du circuit amplificateur 101.

En fonctionnement, le circuit de polarisation 202 de la figure 2 est conçu dans le but de maintenir un produit GMxR, raisonnablement constant quelles que soient les variations de valeurs des résistances 106 et 108 et de la transconductance GM de la paire différentielle 102, 104 résultant de variations de température ou de conditions de fabrication. Ainsi, en supposant une approximation basée sur une équation quadratique (voir ci-dessous), la largeur du transistor 210 est choisie quatre fois plus grande que celle du transistor 206. Les transistors 208 et 212 ont la même largeur, concordant avec la largeur du transistor 112 de la source de courant variable. Le courant dans les deux branches 203 et 204 a une valeur constante I et le courant I doit être égal au courant circulant dans la source de courant variable 112 du circuit amplificateur 101. Ainsi, en appelant $V_{GS1}$ la tension aux bornes du transistor 206, $V_{GS2}$ la tension aux bornes du transistor 210 et R la valeur de la résistance 209, on obtint :

$$V_{DD} - V_{GS1} = V_{DD} - IR - V_{GS2}$$

Le courant $I_{DS}$ dans le transistor 210 est basé sur l'équation quadratique suivante :

$$I_{DS} = (kW/2L)\Delta V_{GS}^2 \qquad\qquad (1)$$

où $\Delta V_{GS}$ est la tension source-grille moins la tension de seuil MOS, k est un paramètre MOS, W est la largeur du transistor et L est la longueur du canal. Il s'ensuit que $\Delta V_{GS1} = IR + \Delta V_{GS2}$ et, étant donné que la largeur du transistor 210 est quatre fois celle du transistor 206, $\Delta V_{GS1} = 2\Delta V_{GS2}$ et donc $\Delta V_{GS2} = IR$. En appelant gm la transconductance du transistor 206, la transconductance du transistor 210 est donc 2gm et, comme gm = $2I/\Delta V_{GS}$, il s'ensuit que gmxR=1.

Un inconvénient du circuit de polarisation 202 est que des valeurs parasites des composants dans le circuit de polarisation ne sont pas bien accordées à celles de l'amplificateur différentiel. En particulier, comme le transistor 210 a une largeur quatre fois plus grande que celle du transistor 206, il n'est pas possible que les deux transistors 206 et 210 soient bien accordés avec les transistors 102, 104 de la paire différentielle.

En outre, le circuit de polarisation 202 est basé sur la loi quadratique de l'équation (1) ci-dessus, alors qu'en pratique, l'inventeur a découvert que ceci n'est plus exact dans le cadre des technologies CMOS actuelles.

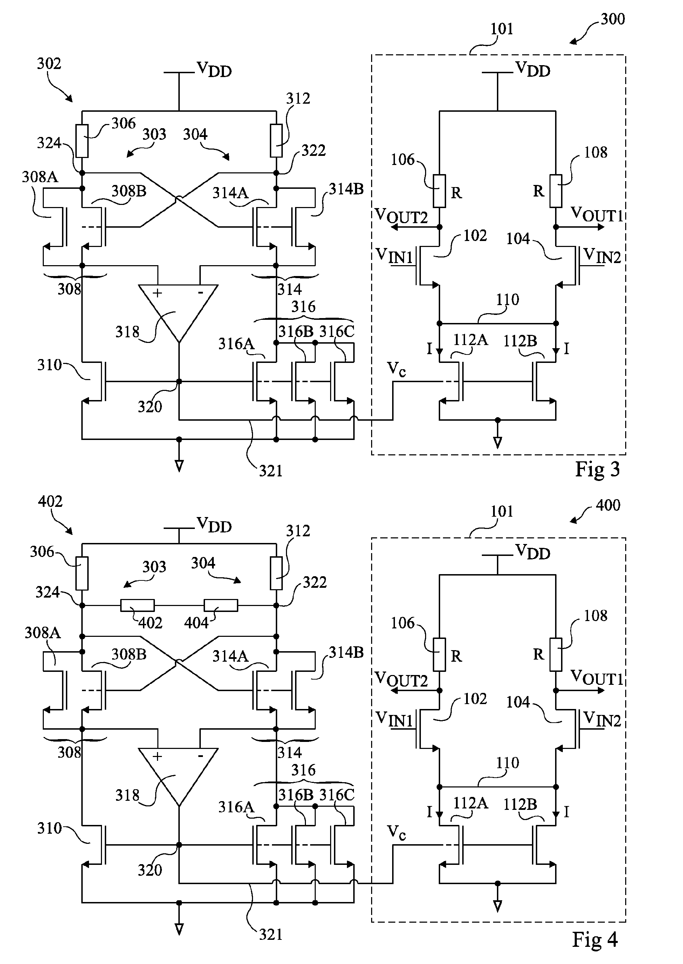

La figure 3 représente un amplificateur différentiel 300 qui comprend à nouveau le circuit amplificateur 101 de la figure 1, comprenant la paire différentielle 102, 104 et d'autres composants 106 à 112 décrits ci-dessus en relation avec la figure 1. En outre, un circuit de polarisation 302 est prévu pour commander la source de courant variable 112 du circuit amplificateur 101.

Le circuit de polarisation 302 comprend deux branches 303, 304 couplées entre la tension d'alimentation $V_{DD}$ et la masse.

La branche 303 comprend une résistance 306, un dispositif MOS 308 et un dispositif MOS 310 en série. Le dispositif MOS 308 comprend deux transistors MOS 308A, 308B en parallèle, leurs sources, drains et grilles respectifs étant interconnectés, alors que, dans cet exemple, le dispositif du transistor 310 est constitué d'un seul transistor. La résistance 306 est couplée entre la tension d'alimentation $V_{DD}$ et les drains de chacun des transistors 308A, 308B.

La branche 304 comprend une résistance 312, un dispositif MOS 314 et un dispositif MOS 316 en série. Le dispositif MOS 314 comprend deux transistors MOS 314A, 314B en parallèle. Le dispositif MOS 316 comprend trois transistors MOS 316A, 316B, 316C en parallèle. La résistance 312 est couplée entre la tension d'alimentation VDD et les drains des transistors 314A, 314B.

Les grilles des transistors 308A, 308B sont connectées aux drains des transistors 314A, 314B et inversement. En d'autres termes, les grilles des transistors 308A, 308B sont couplées à un noeud 322 entre les drains des transistors 314A, 314B et la résistance 312, et les grilles des transistors 314A, 314B sont couplées à un nœud 324 entre les drains des transistors 308A, 308B et la résistance 306. Les sources des transistors 308A, 308B et 314A, 314B, en plus d'être couplées respectivement aux drains du transistor 310 et des transistors 316A, 316B et 316C, sont couplées à des entrées différentielles respectives d'un amplificateur opérationnel 318. La sortie de l'amplificateur opérationnel 318 est couplée à un nœud 320 qui est lui-même couplé aux grilles des transistors 310, 316A, 316B et 316C et à la source de courant variable 112. En particulier, le nœud 320 est couplé par une ligne 321 aux grilles des transistors 112A, 112B du circuit amplificateur 101.

Les transistors 308A, 308B et 314A, 314B ont par exemple tous la même longueur et la même largeur et chacun des transistors 316A, 316B et 316C a par exemple la même longueur et la même largeur que le transistor 310.

Dans certains modes de réalisation, il y a un facteur d'échelle M/N entre le courant 2I dans le circuit amplificateur différentiel 101 et le courant combiné dans les branches 303, 304 du circuit de polarisation 302. Ainsi, il y a par exemple un facteur d'échelle M/N entre la largeur de chaque transistor 102, 104 de la paire différentielle et la largeur combinée des transistors de chaque dispositif 308, 314. De même, il y a un facteur d'échelle M/N entre la largeur combinée des transistors 112A, 112B de la source de courant 112 et la largeur combinée des transistors des dispositifs 310 et 316 du circuit de polarisation 302. Ainsi, par exemple, chaque transistor 102, 104 de la paire différentielle a une largeur équivalente à M fois celle de chaque transistor des dispositifs 308, 314, alors que chaque transistor 112 de la source de courant a une largeur égale à M fois celle de chaque transistor des dispositifs 310, 316.

De façon similaire, il y a par exemple, un facteur N/M entre la valeur des résistances 106, 108 et la valeur des résistances 306 et 312. Ainsi, les résistances 106, 108 ont chacune une valeur R/M alors que les résistances 306 et 312 ont chacune une valeur R/N. Par exemple, les résistances 106 et 108 ont une résistance comprise entre 1 kΩ et 100 kΩ bien que d'autres valeurs soient possibles.

A titre d'exemple, dans le cas où M est égal à 4 et N est égal à 2, chacun des transistors 308A, 308B, 314A, 314B a le quart de la largeur de chaque transistor 102, 104 et chacun des transistors 310, 316A, 316B et 316C a un quart de la largeur de chaque transistor 112A, 112B. En outre, chacune des résistances 306 et 312 a deux fois la valeur de chacune des résistances 106, 108.

En fonctionnement, la connexion croisée des grilles et des drains des transistors 308A, 308B et 314A, 314B impose structurellement au circuit de polarisation 302 les mêmes conditions que dans le circuit amplificateur différentiel 101 quand on a un gain unité, en d'autres termes, quand $V_{IN1}$ est égal à $V_{OUT1}$ et que $V_{IN2}$ est égal à $V_{OUT2}$. En outre, les sources de courant déséquilibrées formées par les transistors 310 et 316A, 316B, 316C imposent des conditions de courant équivalant à une excursion de tension des tensions d'entrée $V_{IN1}$ et $V_{IN2}$. Par exemple, dans le cas où il y a trois transistors 316A, 316B et 316C dont chacun a la même largeur que le transistor 310, un tel circuit est adapté à une excursion de courant dans les transistors 102, 104 comprise entre $I_{bias}-i_{max}$ et $I_{bias}+i_{max}$, où $I_{bias}$ est le courant de repos présent quand il y a un signal d'entrée différentiel nul à l'entrée de l'amplificateur, par exemple 0 volt, et $i_{max}$ est l'amplitude maximum du courant différentiel produit par une tension différentielle maximum à l'entrée du circuit amplificateur différentiel, égale dans ce cas à $I_{bias}/2$. L'amplificateur opérationnel 318 produit une tension sur sa sortie qui entraîne que les tensions de source des transistors 308 et 314 sont égales et, quand cette condition est satisfaite, gmxR=1.

Dans des variantes de réalisation, les dispositifs MOS 308, 310, 314 et 316 pourraient comprendre un nombre différent de transistors MOS en parallèle et il pourrait également y avoir un ou plusieurs transistors supplémentaires couplés en parallèle avec le transistor 310. Selon les caractéristiques du signal d'entrée différentiel $V_{IN1}$, $V_{IN2}$ sur les grilles de la paire différentielle 102, 104, le rapport entre le nombre de transistors 310 et le nombre de transistors du dispositif 316 peut être choisi. De façon générale, en appelant N le rapport $I_{bias}/i_{max}$, le rapport T entre le nombre de transistors du dispositif 316 et le nombre de transistors 310 dans la branche 303 est choisi pour être égal à :

$$T = (N+1)/(N-1)$$

Ainsi, en supposant que N=2, le rapport peut être choisi égal à 3/1, ce qui implique que trois transistors 316A, 316B et 316C en parallèle forment le dispositif 316 et qu'un transistor forme le dispositif 310. A titre de variante, si N=1,5, T=5/1. Dans ce cas, le dispositif 316 comprend par exemple cinq transistors 316A à 316E. A titre d'autre exemple, si N=4, T=5/3, le dispositif 316 comprendra cinq transistors 316A à 316E et le dispositif 310 comprendra trois transistors.

La figure 4 représente un amplificateur différentiel 400 qui est très similaire à l'amplificateur 300 de la figure 3, et de mêmes caractéristiques sont désignées par de mêmes références. Toutefois, dans l'amplificateur 400, un circuit de polarisation 402 comprend, par rapport au circuit de polarisation 302, deux résistances supplémentaires 402 et 404 en série entre les drains des transistors 308A, 308B et 314A, 314B.

Alors que les circuits de la figure 3 sont optimisés pour un gain unité, par l'ajout des deux résistances 402 et 404, le gain de l'amplificateur différentiel 400 peut être optimisé pour des conditions de non-unité. Par exemple, pour atteindre un gain de quatre, chacune des résistances 402, 404 a par exemple une valeur égale au tiers de celle de chacune des résistances 306 et 312. De façon générale, pour un gain G, et en supposant que les résistances 306 et 312 ont chacune une résistance (R/N), chacune des résistances 402, 404 a une résistance égale à (R/N)/(G-1).

Il sera clair pour l'homme de l'art que les résistances 402, 404 pourraient être combinées en une résistance unique.

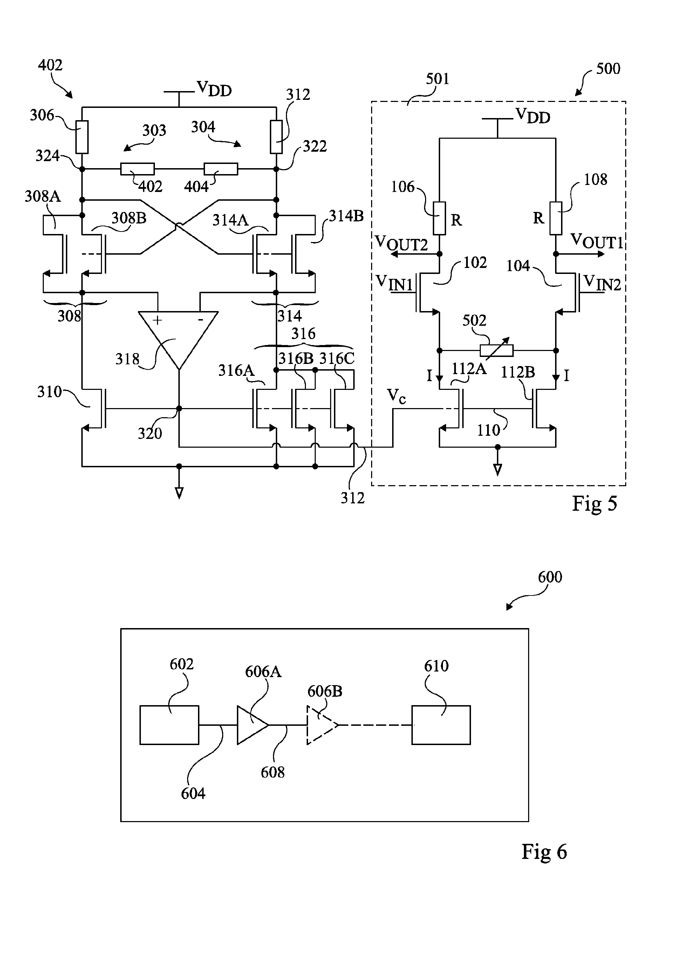

La figure 5 représente un amplificateur différentiel 500 comprenant le même circuit de polarisation 402 que la figure 4 mais comprenant un circuit amplificateur 501 dans lequel une résistance variable supplémentaire 502 est positionnée entre les sources des transistors 102, 104. Ainsi, alors que les résistances 402 et 404 du circuit de polarisation 301 sont utilisées pour déterminer la limite supérieure possible du gain, la résistance 502 peut être utilisée pour faire varier ce gain en dessous du niveau maximum.

La figure 6 représente un dispositif électronique 600 comprenant des moyens d'entrée 602 pour recevoir un signal d'entrée différentiel fourni sur des lignes 604 à un amplificateur différentiel 606A. L'amplificateur 606A comprend par exemple l'amplificateur différentiel des figures 3, 4 ou 5 et est un amplificateur à gain fixe ou à gain variable. La sortie de l'amplificateur différentiel 606A sur une ligne 608 peut être couplée à un ou plusieurs autres amplificateurs différentiels 606B comprenant également le circuit des figures 3, 4 et 5 et/ou couplée à un circuit de traitement 610 qui comprend par exemple des convertisseurs analogique-numérique, un DSP (processeur numérique de signal) ou autres circuits.

Le dispositif électronique 600 est par exemple une commande de disque dur ou autre dispositif pour lire un support de données électroniques tel qu'un disque compact, un disque numérique, une bande magnétique ou analogue. A titre de variante, le dispositif électronique 600 pourrait être un dispositif électronique portable tel qu'un téléphone mobile, un ordinateur portable, un lecteur portable audio ou vidéo, etc. En outre, le dispositif électronique pourrait être un décodeur, un lecteur DVD, un ordinateur personnel ou analogue.

Un avantage des modes de réalisation décrits ici est que des variations des valeurs de résistance et de transconductance des transistors dans le circuit d'amplificateur différentiel peuvent être compensées avec précision. En particulier, on a montré que l'amplitude des fluctuations de courant de sortie provoquée par de telles variations peut être réduite d'un facteur 10 par rapport au circuit de la figure 2. En outre, en prévoyant les résistances 402 et 404, le gain de l'amplificateur différentiel peut être ajusté à un niveau désiré.

De plus, en introduisant une résistance variable 502, le gain de l'amplificateur peut être rendu variable.

Alors que plusieurs modes de réalisation particuliers de la présente invention ont été décrits, il sera clair pour l'homme de l'art que de nombreuses variantes et modifications peuvent être apportées.

Par exemple, alors que, dans les modes de réalisation décrits, tous les transistors sont des transistors MOS à canal N, il sera clair pour l'homme de l'art qu'ils peuvent être remplacés par des transistors MOS à canal P et/ou des transistors bipolaires. En outre, bien que l'on ait décrit des modes de réalisation comprenant des transistors couplés en parallèle, des largeurs de transistors équivalentes pourraient être obtenues en prévoyant au lieu de cela, un ou plusieurs transistors plus grands. Toutefois, l'avantage de l'utilisation de transistors multiples en parallèle est qu'ils s'adaptent avec plus de précision au comportement de la paire différentielle 102, 104 et de la source de courant 112.

Bien qu'une tension de masse de 0 V soit décrite dans les divers modes de réalisation, il sera clair pour l'homme de l'art que la tension de masse pourrait être remplacée par un autre niveau de tension d'alimentation telle qu'une tension négative.

Les diverses caractéristiques décrites en relation avec les divers modes de réalisation peuvent être combinées selon toute combinaison dans des variantes de réalisation.


**Revendications**

1. Circuit de polarisation pour commander le courant circulant dans une paire différentielle (102, 104) d'un circuit amplificateur différentiel (101), le circuit de polarisation comprenant :

   des première et seconde branches (303, 304) dont chacune est couplée entre des première et seconde tensions d'alimentation ($V_{DD}$, Ground), la première branche comprenant une première résistance (306), un premier dispositif de transistor (308) et un deuxième dispositif de transistor (310) en série, et la seconde branche comprenant un troisième dispositif de transistor (314) et un quatrième dispositif de transistor (316) en série ; et un amplificateur opérationnel (318) ayant une première entrée couplée à un noeud disposé entre les premier et deuxième dispositifs de transistor, une seconde entrée couplée à un noeud entre les troisième et quatrième dispositifs de transistor et un noeud de sortie couplé au noeud de commande des deuxième et quatrième dispositifs de transistor, le noeud de sortie étant agencé pour commander le courant circulant dans la paire différentielle, le circuit étant **caractérisé en ce que** la seconde branche comprend une seconde résistance (312) et **en ce qu'**un noeud de commande du troisième dispositif de transistor est couplé à un premier noeud (324) disposé entre la première résistance et le premier dispositif de transistor, et un noeud de commande du premier dispositif de transistor est couplé à un second noeud (322) entre la deuxième résistance et le troisième dispositif de transistor.

2. Circuit de polarisation selon la revendication 1, dans lequel chacun des premier et deuxième dispositifs de transistor comprend deux transistors (308A, 308B, 314A, 314B) en parallèle.

3. Circuit de polarisation selon la revendication 2, dans lequel les transistors des premier et troisième dispositifs de transistor ont la même largeur que chaque transistor de la paire différentielle.

4. Circuit de polarisation selon l'une quelconque des revendications 1 à 3, dans lequel le quatrième dispositif de transistor comprend une pluralité de transistors (316A, 316B, 316C) en parallèle, chacun ayant la même largeur qu'un transistor (112) de la source de courant variable.

5. Circuit de polarisation selon la revendication 4, dans lequel le rapport entre le nombre de transistors du quatrième dispositif de transistor et du deuxième dispositif de transistor est choisi pour être égal à (N+1)/(N-1), où N est le rapport entre un courant de repos et un courant de signal acceptable maximum.

6. Circuit de polarisation selon la revendication 5, dans lequel le rapport entre le nombre de transistors du quatrième dispositif de transistor et du deuxième dispositif de transistor est dans une plage de 1 à 20.

7. Circuit de polarisation selon l'une quelconque des revendications 1 à 6, comprenant en outre au moins une résistance (402, 404) couplée entre les premier et deuxième noeuds.

8. Circuit de polarisation selon l'une quelconque des revendications 1 à 7, dans lequel le quatrième dispositif de transistor comprend trois transistors en parallèle, chacun ayant une largeur égale à la largeur des transistors du deuxième dispositif de transistor de la première branche.

9. Amplificateur différentiel comprenant le circuit de polarisation de l'une quelconque des revendications 1 à 8, et un circuit amplificateur comprenant :

une première résistance (106) couplée entre la première tension d'alimentation ($V_{DD}$) et un premier transistor (102) de la paire différentielle ;
une deuxième résistance (108) couplée entre la première tension d'alimentation ($V_{DD}$) et un deuxième transistor de la paire différentielle ; et
une source de courant variable commandée par le signal de sortie ($V_C$) pour commander le courant circulant dans la paire différentielle.

10. Amplificateur différentiel selon la revendication 9, dans lequel le circuit amplificateur comprend un premier noeud de sortie différentiel ($V_{OUT2}$) entre le premier transistor de la paire différentielle et la première résistance et un second noeud de sortie différentiel ($V_{OUT1}$) entre le second transistor de la paire différentielle et la deuxième résistance (108).

11. Amplificateur différentiel selon la revendication 9 ou 10, dans lequel le circuit amplificateur comprend en outre une première résistance variable (502) couplée entre les sources des premier et deuxième transistors de la paire différentielle et dans lequel la source de courant variable comprend :

un premier transistor (112A) couplé entre la source du premier transistor de la paire différentielle et la seconde tension d'alimentation (Ground) ; et
un deuxième transistor (112B) couplé entre la source du deuxième transistor de la paire différentielle et la seconde tension d'alimentation (Ground).

12. Amplificateur à gain variable (VGA) comprenant l'amplificateur différentiel de la revendication 10.

13. Dispositif électronique comprenant l'amplificateur différentiel de l'une quelconque des revendications 9 à 11.

14. Commande de disque dur pour lire un disque de mémorisation de données électroniques comprenant une tête de lecture et l'amplificateur différentiel de l'une quelconque des revendications 9 à 11.

**15.** Amplificateur comprenant une pluralité des amplificateurs différentiels de l'une quelconque des revendications 9 à 11, en série.

Fig 1

Fig 2

Fig 3

Fig 4

Fig 5

Fig 6

Europäisches
Patentamt

European
Patent Office

Office européen
des brevets

**RAPPORT DE RECHERCHE EUROPEENNE**

Numéro de la demande

EP 10 19 3006

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | US 6 275 109 B1 (TANG ZHI-LONG [US]) 14 août 2001 (2001-08-14) * colonne 3, ligne 66 - colonne 5, ligne 62; figure 2 * ----- | 1-15 | INV. H03F3/45 H03F1/26 H03F1/32 |
| A | EP 0 088 477 A1 (PHILIPS NV [NL]) 14 septembre 1983 (1983-09-14) * page 4, ligne 29 - page 8, ligne 11; figures 1,2,3 * ----- | 1-15 | |
| A | GB 2 428 148 A (AGILENT TECHNOLOGIES INC [US]; AVAGO TECHNOLOGIES GENERAL IP [SG]) 17 janvier 2007 (2007-01-17) * alinéa [0022] - alinéa [0037]; figure 1 * ----- | 1-15 | |
| A | DE 196 39 034 A1 (SIEMENS AG [DE]) 2 avril 1998 (1998-04-02) * page 2, ligne 42 - page 3, ligne 43; figure 1 * ----- | 1-15 | |
| A | US 2008/157875 A1 (BEHZAD ARYA [US] ET AL) 3 juillet 2008 (2008-07-03) * alinéa [0024] - alinéa [0044]; figures 1B,2,3,4,5 * ----- | 1-15 | DOMAINES TECHNIQUES RECHERCHES (IPC) H03F H03G G05F |
| A | JP 1 179507 A (FUJITSU LTD) 17 juillet 1989 (1989-07-17) * abrégé; figure 1 * ----- | 1-15 | |

Le présent rapport a été établi pour toutes les revendications

| Lieu de la recherche | Date d'achèvement de la recherche | Examinateur |
|---|---|---|
| La Haye | 14 mars 2011 | Fedi, Giulio |

EPO FORM 1503 03.82 (P04C02)

**ANNEXE AU RAPPORT DE RECHERCHE EUROPEENNE**
**RELATIF A LA DEMANDE DE BREVET EUROPEEN NO.**

EP 10 19 3006

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

14-03-2011

| Document brevet cité au rapport de recherche | | Date de publication | Membre(s) de la famille de brevet(s) | | Date de publication |
|---|---|---|---|---|---|
| US 6275109 | B1 | 14-08-2001 | AUCUN | | |
| EP 0088477 | A1 | 14-09-1983 | BR | 8301102 A | 22-11-1983 |
| | | | CA | 1194144 A1 | 24-09-1985 |
| | | | DE | 3377169 D1 | 28-07-1988 |
| | | | ES | 8401645 A1 | 01-03-1984 |
| | | | HK | 85491 A | 08-11-1991 |
| | | | JP | 1848738 C | 07-06-1994 |
| | | | JP | 5057609 B | 24-08-1993 |
| | | | JP | 58166412 A | 01-10-1983 |
| | | | NL | 8200974 A | 03-10-1983 |
| | | | US | 4709163 A | 24-11-1987 |
| GB 2428148 | A | 17-01-2007 | US | 2007024262 A1 | 01-02-2007 |
| DE 19639034 | A1 | 02-04-1998 | AUCUN | | |
| US 2008157875 | A1 | 03-07-2008 | AUCUN | | |
| JP 1179507 | A | 17-07-1989 | JP | 2068965 C | 10-07-1996 |
| | | | JP | 7101825 B | 01-11-1995 |

EPO FORM P0460

Pour tout renseignement concernant cette annexe : voir Journal Officiel de l'Office européen des brevets, No.12/82

**EP 2 339 747 A1**

## RÉFÉRENCES CITÉES DANS LA DESCRIPTION

**Documents brevets cités dans la description**

- US 6275109 B